# EUROPEAN PATENT SPECIFICATION

(11) **EP 0 302 659 B1**
(45) Date of publication and mention of the grant of the patent: **06.10.1993**
(21) Application number: 88306931.2
(22) Date of filing: 27.07.1988
(51) Int. Cl.: H01L 27/10, H01L 21/82, H01L 29/62, G11C 17/00

(54) **Semiconductor memory device and process for producing same**
Halbleiterspeichervorrichtung und Herstellungsverfahren
Dispositif semi-conducteur à mémoire et son procédé de fabrication

(30) Priority: 27.07.1987 JP 188148/87
(43) Date of publication of application: 08.02.1989
(73) Proprietor: SHARP KABUSHIKI KAISHA, Osaka 545 (JP)
(72) Inventor: Ashida, Tsutomu, Yamatokoriyama-shi Nara-ken (JP); Okada, Mikiro, Nara-shi Nara-ken (JP)
(74) Representative: Brown, Kenneth Richard

(56) References cited:
- US-A- 4 328 563
- US-A- 4 342 100
- IBM TECHNICAL DISCLOSURE BULLETIN, vol. 23, no. 6, November 1980, pages 2245-2246, New York, US; E. ADLER: "Self-aligned, ion-implanted read-only memory"

## Description

The present invention relates to semiconductor memory devices, and more particularly to read-only memories (hereinafter referred to as "ROMs").

ROMs for use in storing various items of program data generally comprise a plurality of MIS transistors in the form of a matrix of gate wiring and source and drain regions.

Such ROMs are, in a predetermined manner, either open-circuit between the source and drain regions of the transistors, or short-circuited between the source and drain regions, or inactivated between the source and drain regions with increased thickness of insulating film under the gate wiring (i.e., gate insulating film), whereby currents between the drain and the source are detected or non-detected and hence the memory data unit "1" or "0" is stored. Such a ROM device is known from US-A-4 342 100.

The so-called LOCOS (Local Oxidation Silicon) process (Electronics, December 20, p. 45, (1971); "MOS Device," Complete Book of Electronics Techniques, pp. 290-291 Kogyo Chosakai (Industrial Research Association), (1976)) is used for forming thick insulating films for use in ROMs.

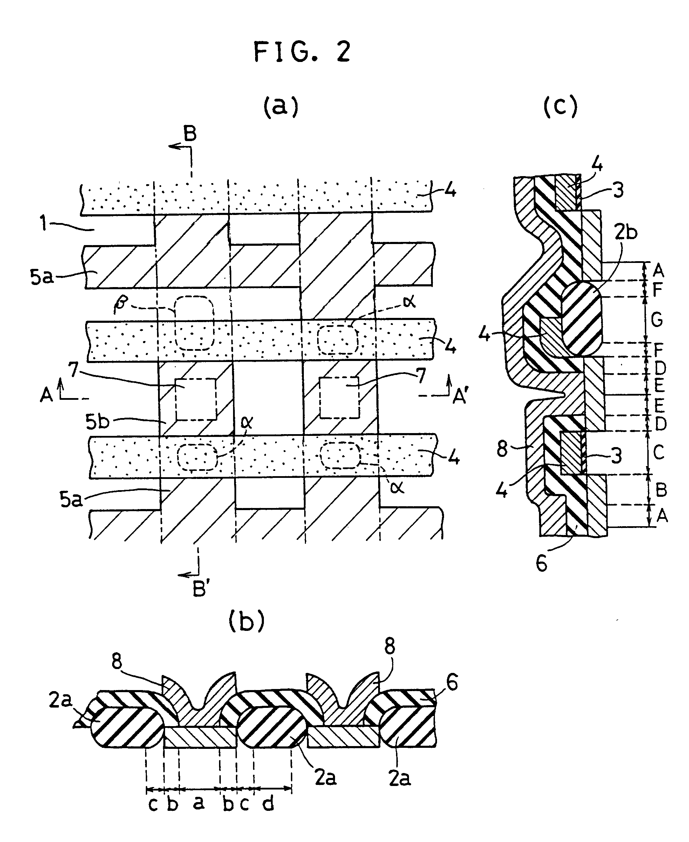

Figure 2 (a) is a plan view of a conventional silicon-gate ROM, Figure 2 (b) is a view in section taken along the line A-A' in Figure 2 (a), and Figure 2 (c) is a view in section taken along the line B-B' in Figure 2 (a). Oxide films 2a and 2b are formed by the LOCOS process on the cell separating regions and inactive transistor gate regions of a semiconductor substrate 1. A gate oxide film 3 is formed on the gate regions of the semiconductor substrate providing active transistors. Gate wiring 4 of polysilicon is then formed on the substrate 1, and semiconductor regions providing source regions 5a and drain regions 5b are thereafter formed on the substrate 1 using the oxide films 2a, 2b and the gate wiring 4 for masking. Subsequently, an interlayer insulating film 6 of NSG, BPSG or the like is formed on the substrate 1, contact holes 7 are formed in the interlayer insulating film 6 on the drain regions 5b, and metal wiring 8 is thereafter provided in contact with the drain regions 5b.

Thus, the oxide film 2b having a larger thickness than the gate film 3 is formed in the gate regions (β) of the inactive transistors by the LOCOS process, so that when such a transistor is selected for reading out data, no current flows between the source region 5a and the drain region 5b. This corresponds, for example to the memory data unit "0". Accordingly various items of data can be stored using the combination of this unit with the memory data unit, for example, of "1" at the gate region (α) of the active transistor.

However, when thick insulating films are formed by the LOCOS process, the film formed invariably has a larger width than is intended owing to the influence of internal diffusion of oxygen during thermal oxidation. The ratio of increase in the width is greater when the specified width is smaller.

Accordingly, ROM cells having such a thick insulating film in the cell separating region and as the gate inactivating film are limited in design by the increase in the film width, which imposes limitations on the provision of ROMs of greater complexity.

This will be described more specifically with reference to the conventional ROM described which must have the following pitches, for example, according to the 1.0-µm rule. As shown in Figure 2 (b), the horizontal pitch required is 3.6 µm, which is the total of 1 µm for a space a for the contact hole 7, 0.4 µm for each of two portions of allowance b for the alignment of the contact hole 7 with the drain region 5b, 0.4 µm for each of two edge portions c of the oxide film 2a formed by the LOCOS process and providing a cell separating region, and 1 µm for a space d for the oxide film 2a formed by the LOCOS process and providing a cell separating region.

With reference to Figure 2 (c), the vertical pitch for the active transistor is 3.2 µm, which is the total of 0.5 µm for a half portion A of the source region 5a, 0.8 µm for an allowance B for the alignment of the gate 4 with the source area 5a, 1 µm for the width C of the gate 4, 0.4 µm for an allowance D for aligning the gate 4 with the contact hole 7, and 0.5 µm for one half portion E of the contact hole 7. With the inactive transistor, the vertical pitch is 3.2 µm, which is the total of 0.5 µm for the other half portion E of the contact hole 7, 0.4 µm for an allowance D for aligning the gate wiring 4 with the contact hole 7, 0.4 µm for each of two edge portions F of the oxide film 2b formed by the LOCOS process in the gate region of the inactive transistor, 1 µm for a space G for the oxide film 2b, and 0.5 µm for a half portion A of the source region 5a. The pitch required is 3.2 µm regardless of whether the transistor is active or inactive.

Thus, there is a need to provide spaces which are not directly relevant to the separation of cells or to the inactivation of transistors, i.e. the edge portions c of the oxide film 2a and the edge portions F of the oxide film 2b. Consequently, each cell requires a large space (in the above case, 3.6 µm x 3.2 µm = 11.52 µm²) which is objectionable in providing compact ROMs of higher complexity.

The main object of the present invention, which has been accomplished to overcome the above problem, is to provide a semiconductor memory device which is remarkably improved in complexity over conventional ones.

The invention provides a semiconductor memory device comprising:
(a) a p-type (or n-type) semiconductor substrate,
(b) a group of n-type (or p-type) semiconductor regions formed in the surface layer of the substrate in the form of strips arranged in parallel at a predetermined spacing, the semiconductor regions providing alternating source regions and drain regions and defining gate regions between the alternating regions,
(c) a group of strips of first gate insulating film formed on the surface of the substrate at a predetermined spacing and intersecting the group of semiconductor regions,
(d) a first gate electrode formed on each of the strips of first gate insulating film,
(e) a second gate insulating film having substantially the same thickness as the first gate insulating film being formed on that portion of the surface of the substrate not being covered by the first gate insulating film, and
(f) a second gate electrode formed on each of the strips of second gate insulating film and held out of contact with the first gate electrode,
whereby a matrix of MIS transistor cells is formed, a cell being provided at each intersection of one of the gate regions and one of the first or one of the second electrodes,
the gate regions of some of the cells being selectively doped with a p-type (or n-type) impurity substance at a higher concentration than the substrate.

According to the invention there is also provided a method of reading a device as described above, comprising:
simultaneously applying a first voltage (selection voltage) to a selected gate electrode sufficient to make conducting the transistors associated therewith that have not been selectively doped to said higher concentration and insufficient to make conducting the transistors associated therewith that have been selectively doped to said higher concentration; and
applying a second voltage (reference voltage) to at least those gate electrodes immediately adjacent to said selected gate electrode sufficient to make the transistors associated with said adjacent gate electrodes non-conductive so that the semiconductor surface region under said adjacent gate electrodes functions as a cell separating region.

The invention further provides a process for producing a semiconductor memory device comprising the steps of:
(a) forming a plurality of n-type (or p-type) semiconductor regions in the form of parallel strips in the surface layer of a p-type (or n-type) semiconductor substrate, the semiconductor regions providing alternating source regions and drain regions and defining gate regions therebetween and with a first insulating film formed over substantially the entire surface of the semiconductor substrate,
(b) forming on the first insulating film a plurality of first gate electrodes in the form of parallel strips intersecting the semiconductor region,
(c) removing the first insulating film from the substrate surface portions between the first gate electrodes utilising the electrodes for masking to form strips of first gate insulating film,
(d) forming a second gate insulating film, having substantially the same thickness as the first gate insulating film on that portion of the substrate surface not being covered by the first gate insulating film, and
(e) forming a second gate electrode on each portion of the second gate insulating film,
the gate regions of cells provided by the intersections of the gate regions with the gate electrodes being selectively doped by ion implantation with a p-type (or n-type) impurity substance at a higher concentration than the substrate at the stage after any of the steps (a) - (e).

The present invention has been accomplished directing attention to the following. When selected gate regions are doped with impurities at a higher concentration than the substrate, the transistors concerned can be inactivated without forming a thick insulating film. When two groups of wiring are arranged closely alternately, the non-selected gate electrodes other than the selected gate electrodes are given a potential which renders the transistors under the non-selected gate electrodes non-conductive, so that the semiconductor surface region under the non-selected gate electrode adjacent to the selected gate electrode can be made to function as a kind of cell separating region.

This makes it possible to provide a ROM which is exceedingly greater in complexity, i.e. memory capacity, than the conventional devices.

The cell (transistor) having a gate region doped with impurities at a high concentration has a higher threshold gate voltage Vth than the one not doped to the high concentration. The difference results in the following. With a reference voltage, lower than the threshold voltage A of the latter transistor, applied to the electrodes of these two transistors, a voltage (selection voltage) higher than the threshold voltage A but lower than the threshold voltage B of the former transistor is applied to one of the electrodes. The transistor not having the high dopant concentration is then brought into conduction, whereas the highly doped transistor remains non-conductive. The former state corresponds to the memory data unit, for example, of "1", and the latter to the memory data unit, for example of "0".

The device of the invention, which does not require the conventional cell separating region is greatly reduced in the required area per transistor. This makes it possible to integrate transistors with greater complexity and to provide compacted ROM memory cells.
Figure 1 (a) is a plan view showing an embodiment of the invention;
Figure 1 (b) is a view in section taken along the line A-A' in Figure 1 (a);
Figure 1 (c) is a view in section taken along the line B-B' in Figure 1 (a);
Figure 2 (a) is a plan view of a conventional device;
Figure 2 (b) is a view in section taken along the line A-A' in Figure 2 (a); and
Figure 2 (c) is a view in section taken along the line B-B' in Figure 2 (a).

The first and second gate insulating films according to the invention can be usual gate insulating films of SiO₂, Si₃N₄ or the like. It is suitable that these films be 10 nm (100 angstroms) to 100 nm (1000 angstroms) in thickness in view of the insulating property and application of an electric field. The films can be formed by the usual thermal oxidation method, CVD method, etc. The second gate insulating film is so formed as to cover each edge portion of the gate electrode which is formed in the shape of a strip having a specified width on each strip of first gate insulating film. This is desirable to inhibit or diminish the leakage current between the cells.

The first and second gate electrodes of the invention are formed each in the form of a strip on the first and second gate insulating films, respectively. Examples of suitable materials for forming these electrodes are A1 and the like metals, polycrystalline silicon, metals, such as W, Ti, Pt and Mo, having a high melting point, and silicides thereof such as WSi, WSi and WTiSI.

The semiconductor substrate to be used in the invention can be made of various materials generally used in the art. Usually Si substrates are suitable. The group of semiconductor regions opposite to the substrate in conductivity, each group of insulating film strips, and each group of gate electrodes can be formed by usual methods as by lithography. The number of lines thereof can be determined suitably in accordance with the contemplated memory capacity.

The impurity substance for doping the selected gate regions at a high concentration is of the same conductivity type as the substrate. Suitably, the high concentration is about 10² to about 10⁵ times the impurity concentration of the substrate. It is usually suitable to accomplish such high-concentration doping by ion implantation.

The semiconductor memory device of the invention may have attached thereto a portion or circuit, such as external wiring or external insulating film formed with contact holes for the gate electrodes.

### Example

With reference to the drawings concerned, an example of the invention will be described below, but the invention is not limited to the example.

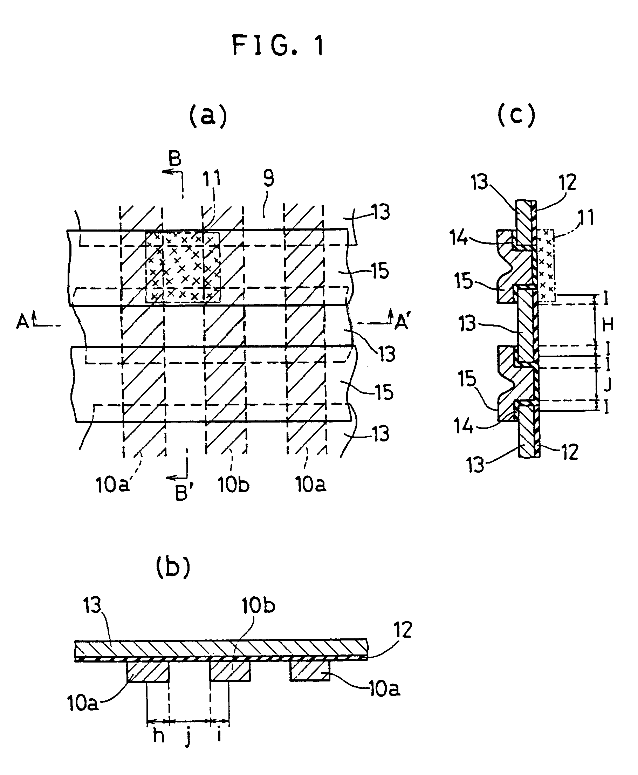

Figure 1 (a) is a plan view showing an embodiment of the invention, Figure 1 (b) is a view in section taken along the line A-A' in Figure 1 (a), and Figure 1 (c) is a view in section taken along the line B-B' therein.

The components of the embodiment will be described stepwise according to the production process thereof.

First in the main surface of a semiconductor substrate 9 of the first conductivity type, impurity regions 10 are formed which provide source regions 10a and drain regions 10b. The semiconductor substrate used for the present embodiment is a p-type silicon single-crystal substrate containing 7 x 10¹⁴ ats. /cm³ of p-type impurities (boron). The impurity regions 10, which are of the second conductivity type, are formed in the surface layer of the substrate 9 approximately in parallel by the ion implantation of n-type impurities (phosphorus at a concentration of 1 x 10²⁰ ats./cm³).

Next, impurity regions 11 of the first conductivity type of square pattern are selectively locally formed in the spaces (gate regions) between the source regions 10a and the drain regions 10b of the substrate 9. A first gate oxide film 12 is then formed substantially over the entire surface of the resulting substrate 9. The impurity (high-concentration) regions 11 are formed by the ion implantation of boron at about 1000 times (7 x 10¹⁷ ats./cm³) the concentration of the substrate. The gate oxide film 12 is formed by thermal oxidation in dry O₂ gas and is about 20 nm (200 angstroms) in thickness. The impurity regions 11 of the first conductivity type may be formed after forming second gate wiring, by ion implantation.

Subsequently, pieces of first gate wiring 13 of polysilicon are formed by the CVD process on the first gate oxide film 12 over the substrate 9, approximately in parallel to intersect the impurity regions 10 of the second conductivity type.

The first gate oxide film 12 is then etched away from the portions of the substrate 9 which are left uncovered by the first gate wiring 13 to expose the substrate portions. A second gate oxide film 14, about 20 nm (200 angstroms) in thickness, is thereafter formed by thermal oxidation over the entire surface of the substrate 9. The second gate oxide film 14 covers not only the exposed surface portions of the substrate 9 but also the edge portions of the first gate wiring 13 as illustrated. Next, second gate wiring 15 of polysilicon is formed by the CVD process between the pieces of first gate wiring 13. The second gate wiring 15 is provided not only between the wiring portions 13, but also over the opposed side faces of the wiring 13. Subsequently, the second gate oxide film 14 left uncovered by the second gate wiring 15 is etched away. An interlayer insulating film, contact holes and metal wiring are thereafter formed by the known CVD process, photoetching and PVD process on the substrate 9 which is almost covered with the first gate wiring 13 and second gate wiring 15 to obtain a masked ROM having double-layer polysilicon gates.

Although the second gate wiring 15 of the above embodiment extends over the side faces of the first gate wiring 13, the wiring 15 can be formed without being so extended.

With this ROM, the transistor having as its channel the impurity region 11 of the first conductivity type doped with impurities of the same conductivity type as those in the semiconductor substrate 9 has a higher threshold voltage than the one free from impurity dopant and remains non-conductive even if selected by application, for example, of a gate voltage of 5 V. Accordingly, the gate regions can be made to correspond to the memory data unit of "1" or "0" in accordance with the presence or absence of the impurity region of the first conductivity type.

The ROM of the invention described above must have the following dimensions when conforming to the 1.0-µm rule. With reference to Figure 1 (b), the horizontal pitch required is 2 µm, which is the total of 0.5 µm for a half portion h of the source region 10a, 0.5 µm for a half portion i of the drain region 10b and 1 µm for the spacing (gate region) j between the source region 10a and the drain region 10b. With reference to Figure 1 (c), the vertical pitch required for the transistor having the first gate 13 is 1.4 µm, which is the total of 1.0 µm for the width H of the first gate 13, and 0.4 µm for two half portions I of the lap of the second gate 15 over the first gate 13. The vertical pitch required for the transistor having the second gate 15 is 1.4 µm, which is the total of 1.0 µm for the width J of the second gate 15, and 0.4 µm for two half portions I of the lap of the second gate 15 over the first gate 13. Thus, the vertical pitch required is 1.4 µm regardless of the gate of the transistor. Since the contacts can be provided concentrically at the peripheral portion of the memory, the area required for the contacts exerts no influence on the memory cells.

Since the ROM of the invention does not require any cell separating region formed by the LOCOS process, the transistor pitch is, for example, 2 µm horizontally and 1.4 µm vertically, hence exceedingly smaller than the conventional ones in the area required. More specifically, in the case of the 1.0-µm rule, the area of the cell of the invention is 2.8 µm² which is about ¼ of the area 11.52 µm² conventionally needed as already mentioned.

Accordingly, the invention provides ROMs of much higher complexity than heretofore available which are suited as ROMs of 8 Mbits, 16 Mbits or higher complexity.

## Claims

1. A semiconductor memory device comprising:
(a) a p-type (or n-type) semiconductor substrate,
(b) a group of n-type (or p-type) semiconductor regions formed in the surface layer of the substrate in the form of strips arranged in parallel at a predetermined spacing, the semiconductor regions providing alternating source regions and drain regions and defining gate regions between the alternating regions,
(c) a group of strips of a first gate insulating film formed on the surface of the substrate at a predetermined spacing and intersecting the group of semiconductor regions,
(d) a first gate electrode formed on each of the strips of first gate insulating film,
(e) a second gate insulating film having substantially the same thickness as the first gate insulating film being formed on that portion of the surface of the substrate not being covered by the first gate insulating film, and
(f) a second gate electrode formed on each of the strips of second gate insulating film and held out of contact with the first gate electrode,
whereby a matrix of MIS transistor cells is formed, a cell being provided at each intersection of one of the gate regions and one of the first or one of the second electrodes, the gate regions of some of the cells being selectively doped with a p-type (or n-type) impurity substance at a higher concentration than the substrate.

2. A device as defined in claim 1 wherein the second gate insulating film covers the edges of the first gate electrodes adjacent thereto.

3. A device as claimed in claim 1 wherein the semiconductor surface region under the non-selected gate electrode adjacent to each selected gate electrode functions as a cell separating region.

4. A process for producing a semiconductor memory device comprising the steps of:
(a) forming a plurality of n-type (or p-type) semiconductor regions in the form of parallel strips in the surface layer of a p-type (or n-type) semiconductor substrate, the semiconductor regions providing alternating source regions and drain regions and defining gate regions therebetween and with a first insulating film formed over substantially the entire surface of the semiconductor substrate,
(b) forming on the first insulating film a plurality of first gate electrodes in the form of parallel strips intersecting the semiconductor regions,
(c) removing the first insulating film from the substrate surface portions between the first gate electrodes utilising the electrodes for masking to form strips of first gate insulating film,
(d) forming a second insulating film, having substantially the same thickness as the first gate insulating film, on that portion of the substrate surface not being covered by the first gate insulating film, and
(e) forming a second gate electrode on each portion of the second insulating film,
the gate regions of cells provided by the intersections of the gate regions with the gate electrodes being selectively doped by ion implantation with a p-type (or n-type) impurity substance at a higher concentration than the substrate at the stage after any of the steps (a) - (e).

5. A process as defined in claim 4 wherein the second gate insulating film covers the edges of the first gate electrodes adjacent thereto.

6. A method of reading a device as claimed in claim 1 comprising:
simultaneously applying a first voltage (selection voltage) to a selected gate electrode sufficient to make conducting the transistors associated therewith that have not been selectively doped to said higher concentration and insufficient to make conducting the transistors associated therewith that have been selectively doped to said higher concentration; and
applying a second voltage (reference voltage) to at least those gate electrodes immediately adjacent to said selected gate electrode sufficient to make the transistors associated with said adjacent gate electrodes non-conductive so that the semiconductor surface region under said adjacent gate electrodes functions as a cell separating region.

## Patentansprüche

1. Halbleiterspeichervorrichtung mit:
(a) einem p-leitenden (oder n-leitenden) Halbleiter-Substrat,
(b) einer in der Oberflächenschicht des Substrats In Form von parallelen Streifen eines bestimmten Abstands ausgebildeten Gruppe von n-leitenden (oder p-leitenden) Halbleiter-Bereichen, die wechselweise Source-Bereiche und Drain-Bereiche und dazwischen angeordnete Gate-Bereiche definieren,
(c) einer Gruppe von auf der Oberfläche in bestimmten Abständen ausgebildeten Streifen aus einem ersten gate-isolierenden Film, die die Gruppe von Halbleiter-Bereichen kreuzen,
(d) einer ersten Gate-Elektrode, die aufjedem der Streifen des ersten gate-isolierenden Films ausgebildet ist,
(e) einem zweiten gate-isolierenden Film, der im wesentlichen die gleiche Dicke wie der erste gate-isolierende Film aufweist und auf dem Teil der Oberfläche des Substrats ausgebildet ist, der nicht durch den ersten gateisolierenden Film abgedeckt ist, und mit
(f) einer zweiten Gate-Elektrode, die aufjedem Streifen des zweiten gate-isolierenden Films ausgebildet ist und nicht in Kontakt mit der ersten Gate-Elektrode steht, bei welcher Halbleiterstruktur
eine Matrix von MIS-Transistorzellen und eine Zelle anjeder Kreuzung von einem der Gate-Bereiche mit einer der ersten oder einer der zweiten Elektroden ausgebildet ist, wobei die Gate-Bereiche einiger Zellen selektiv mit einer p-leitenden (oder n-leitenden) Verunreinigung mit höherer Konzentration als das Substrat dotiert sind.

2. Vorrichtung nach Anspruch 1, bei welcher der zweite gate-isolierende Film die Ecken der daran angrenzenden ersten Gate-Elektroden abdeckt.

3. Vorrichtung nach Anspruch 1, bei welcher der Halbleiterflächenbereich unter der nicht-gewählten Gate-Elektrode angrenzend an jede ausgewählte Gate-Elektrode einen Zellen-trennenden Bereich bildet.

4. Verfahren zur Herstellung einer Halbleiterspeichervorrichtung, mit folgenden Verfahrenschritten:
(a) Bilden einer Mehrzahl von n-leitenden (oder p-leitenden) Halbleiter-Bereichen in Form von parallelen Streifen in der Oberflächenschicht eines p-leitenden (oder n-leitenden) Halbleiter-Substrats, wobei die Halbleiter-Bereiche wechselnde Source-Bereiche und Drain-Bereiche aufweisen und damit Gate-Bereiche definieren und mit einem ersten isolierenden Film, der im wesentlichen über der gesamten Oberfläche des Halbleiter-Substrats ausgebildet ist,
(b) Bilden einer Mehrzahl von ersten Gate-Elektroden auf dem ersten isolierenden Film in Form von parallelen Streifen, die die Halbleiter-Bereiche kreuzen,
(c) Entfernen des ersten isolierenden Films von Teilen der Substratoberfläche zwischen den ersten Gate-Elektroden und Verwenden der Elektroden zur Abdeckung, um Streifen des ersten gate-isolierenden Films zu bilden,
(d) Bilden eines zweiten isolierenden Films mit im wesentlichen gleicher Dicke wie der erste gate-isolierende Film auf dem Teil der Substrat-Oberfläche, die nicht durch den ersten gate-isolierenden Film abgedeckt ist, und
(e) Bilden einer zweiten Gate-Elektrode aufjedem Teil des zweiten isolierenden Films,
wobei die Gate-Bereiche der Zellen, die durch die Kreuzungen der Gate-Bereiche mit den Gate-Elektroden gebildet werden, nach irgendeinem der Schritte (a) - (e) selektiv durch Ionen-Implantation mit einer p-leitenden (oder n-leitenden) Verunreinigung einer höheren Konzentration als das Substrat dotiert werden.

5. Verfahren nach Anspruch 4, bei dem der zweite gate-isolierende Film die Ecken der daran angrenzenden ersten Gate-Elektroden abdeckt.

6. Verfahren zum Lesen einer Vorrichtung nach Anspruch 1, bei dem eine erste Spannung (Selektions-Spannung) an eine gewählte Gate-Elektrode gleichzeitig mit einem Pegel angelegt wird, der ausreicht, um die damit verbundenen Transistoren, die nicht selektiv auf die höhere Konzentration dotiert worden sind, leitend zu schalten, die jedoch nicht ausreicht, um diejenigen Transistoren, die selektiv auf die höhere Konzentration dotiert worden sind, leitend zu schalten; und bei dem
eine zweite Spannung (Referenz-Spannung) mindestens diejenigen Gate-Elektroden, die unmittelbar an die selektierte Gate-Elektrode angrenzen, mit ausreichendem Pegel beaufschlagt, um die Transistoren, die mit den angrenzenden Gate-Elektroden verbunden sind, zu sperren, so daß der Oberflächenbereich des Halbleiters unter den angrenzenden Gate-Elektroden als ein Zellen-trennender Bereich wirkt.

## Revendications

1. Dispositif de mémoire à semi-conducteur comportant :
(a) un substrat semi-conducteur de type p (ou de type n),
(b) un groupe de régions semi-conductrices de type n (ou de type p) formées dans la couche superficielle du substrat sous la forme de bandes disposées en parallèle suivant un espacement prédéterminé, les régions semi-conductrices fournissant des régions de source et des régions de drain alternées et définissant des régions de porte entre les régions alternées,
(c) un groupe de bandes d'un premier film d'isolation de porte formées sur la surface du substrat suivant un espacement prédéterminé et intersectant le groupe de régions semi-conductrices,
(d) une première électrode de porte formée sur chacune des bandes du premier film d'isolation de porte,
(e) un second film d'isolation de porte ayant sensiblement la même épaisseur que celle du premier film d'isolation de porte formé sur la partie de la surface du substrat qui n'est pas recouverte par le premier film d'isolation de porte, et
(f) une seconde électrode de porte formée sur chacune des bandes du second film d'isolation de porte et maintenue hors de contact avec la première électrode de porte,
une matrice de cellules de transistor MIS étant formée, une cellule étant formée au niveau de chaque intersection entre l'une des régions de porte et l'une des premières ou l'une des secondes électrodes, les régions de porte de certaines des cellules étant dopées de façon sélective avec une impureté de type p (ou de type n) suivant une concentration supérieure à celle du substrat.

2. Dispositif selon la revendication 1, dans lequel le second film d'isolation de porte recouvre les bords des premières électrodes de porte qui sont adjacentes à celui-ci.

3. Dispositif selon la revendication 1, dans lequel la région superficielle semi-conductrice se trouvant sous l'électrode de porte non sélectionnée adjacente à chaque électrode de porte sélectionnée fonctionne en tant que région de séparation de cellules.

4. Procédé de fabrication d'un dispositif de mémoire à semi-conducteur comportant les étapes consistant :
(a) à former une multiplicité de régions semi-conductrices de type n (ou de type p) sous la forme de bandes parallèles dans la couche superficielle d'un substrat semi-conducteur de type p (ou de type n), les régions semi-conductrices fournissant des régions de source et des régions de drain alternées et definissant des régions de porte entre elles, et un premier film d'isolation étant formé sur sensiblement toute la surface du substrat semi-conducteur,
(b) à former sur le premier film d'isolation une multiplicité de premières électrodes de porte sous la forme de bandes parallèles intersectant les régions semi-conductrices,
(c) à enlever le premier film d'isolation des parties de surface du substrat se trouvant entre les premières électrodes de porte en utilisant les électrodes aux fins de masquage pour former des bandes de premier film d'isolation de porte,
(d) à former un second film d'isolation, ayant sensiblement la même épaisseur que celle du premier film d'isolation de porte, sur la partie de la surface du substrat qui n'est pas recouverte par le premier film d'isolation de porte, et
(e) à former une seconde électrode de porte sur chaque partie du second film d'isolation,
les régions de porte de cellules formées par les intersections des régions de porte avec les électrodes de porte étant dopées de façon sélective par implantation ionique avec une impureté de type p (ou de type n) suivant une concentration plus élevée que celle du substrat au stade suivant l'une quelconque des étapes (a) à (e).

5. Procédé selon la revendication 4, dans lequel le second film d'isolation de porte recouvre les bords des premières électrodes de porte qui y sont adjacentes.

6. Procédé de lecture d'un dispositif selon la revendication 1 consistant :
à appliquer simultanément une première tension (tension de sélection) à une électrode de porte sélectionnée suffisante pour rendre conducteurs les transistors associés à celle-ci et qui n'ont pas été dopés de façon sélective suivant ladite concentration plus élevée, et insuffisante pour rendre conducteurs les transistors associés à celle-ci qui ont été dopés de façon sélective suivant ladite concentration plus élevée ; et
à appliquer une seconde tension (tension de référence) à au moins les électrodes de porte immédiatement adjacentes à ladite électrode de porte sélectionnée suffisante pour rendre non conducteurs les transistors associés auxdites électrodes de porte adjacentes de sorte que la région superficielle semi-conductrice se trouvant sous lesdites électrodes de porte adjacentes fonctionne en tant que région de séparation de cellules.
